# EUROPEAN PATENT APPLICATION

(11) **EP 2 662 655 A1**
(43) Date of publication of application: **13.11.2013**
(21) Application number: 11855235.5
(22) Date of filing: 26.12.2011
(51) Int. Cl.: F28D 15/02

(54) **TEMPERATURE CONTROL DEVICE AND METHOD FOR MANUFACTURING SAME**

(30) Priority: 07.01.2011 JP 2011002210
(71) Applicant: NHK Spring Co., Ltd., Yokohama-shi, Kanagawa 236-0004 (JP)
(72) Inventor: KAWASAKI, Koichi, Yokohama-shi Kanagawa 236-0004 (JP)
(74) Representative: HOFFMANN EITLE
(86) International application number: PCT/JP2011/080124
(87) International publication number: WO 2012/093613

(57) **Abstract**

A heat pipe (12) including a heat absorption part (12a) provided at one end side and absorbing heat from an outside and a heat dissipation part (12b) provided at another end side and dissipating heat to the outside, and a heat absorption plate (13) and a heat dissipation plate (14) (heat conducting plates) made of metal films formed by powder including metal being accelerated with a gas toward external surfaces of the heat absorption part (12a) and/or the heat dissipation part (12b) of the heat pipe (12) and being sprayed and deposited on the surfaces in a solid-phase state are provided.

## Description

### Field

The present invention relates to a temperature control device used between electrical circuit boards and the like and a method of manufacturing the same. Background

Conventionally, a temperature control device (a cooling device or a heating device) that distributes or circulates a heating medium, which cools or heats a surface of a board, has been used, in various board processes in manufacturing a semiconductor, a liquid crystal display device, an optical disk, and the like. Such a temperature control device is produced, for example, by disposing and allowing a heat pipe to be in contact with an upper side and/or a lower side of the board. Since the heat pipe has a good heat transfer property, the heat pipe can efficiently transfer heat of the heating medium from the board to an outside or from the outside to the board, and can promptly control a board temperature.

The heat pipe has a cylindrical shape that forms an inner space, both ends of which are closed in a vacuum state. The heat pipe includes a heat absorption part provided at one end side and absorbing heat from the outside, and a heat dissipation part provided at another end side and dissipating heat to the outside. Further, a capillary structure, called a wick, is formed on a wall surface of the inner space of the heat pipe, and a liquid (for example, water and a small amount of alcohol) is enclosed.

In the heat pipe, when heat is applied from the outside to the heat absorption part, the liquid enclosed inside is evaporated, and vapor is moved to the heat dissipation part. At this time, since the inner space of the heat pipe is in a vacuum state, the liquid is vaporized at or less than a boiling temperature under ordinary pressure. The vapor moved to the heat dissipation part returns to a liquid again, and moves to the heat absorption part by capillary phenomenon of the wick. As described above, in the heat pipe, the liquid enclosed inside repeats evaporation and condensation between the heat absorption part and the heat dissipation part, so that prompt heat transfer is performed.

Further, the heat absorption part and the heat dissipation part of the heat pipe improve the efficiency of heat absorption and heat dissipation by being joined with heat conducting plates. Here, in the heat conducting plate, the heat absorption part is joined to a heat absorption plate, for example. This heat absorption plate allows the heat absorption part to transfer heat generated by the board and the like arranged at other positions on the heat absorption plate. Also, the heat dissipation part is joined to a heat dissipation plate, and dissipates the heat transferred from the heat absorption part to the heat dissipation part to the outside through the heat dissipation plate.

Conventionally, a heat pipe joined to a heat conducting plate by solder has been known, the heat conducting plate having a board as an object to be temperature-controlled disposed thereon (for example, see Patent Literature 1). Further, a heat pipe type cooler that suppresses effects of heat in solder joint is disclosed, in which an insertion hole is formed in a plate to which a heat pipe is disposed, and one end portion of the heat pipe is inserted to the insertion hole and the heat pipe and the plate are connected (for example, see Patent Literature 2).

### Citation List

### Patent Literature

Patent Literature 1: Japanese Patent Application Laid-open No. 6-181396
Patent Literature 2: Japanese Patent Application Laid-open No. 7-142653

### Summary

### Technical Problem

However, in the joint by solder disclosed in Patent Literature 1, although the strength of the joint between the heat conducting plate and the heat pipe can be secured, the heat pipe may be damaged by heat applied at the time of the solder joint. Further, peeling and cracks are easily caused in the formation of solder, and the formation is coarsened when being held under a high-temperature environment for a long time, so that the strength is lowered. Therefore, there is a problem that reliability of the joint strength between the heat pipe and the heat absorption part (heat dissipation part) is low.

Further, in the heat pipe type cooler disclosed in Patent Literature 2, the heat pipe is not damaged by heat. However, it is structured such that the heat pipe is inserted to the insertion hole, and therefore, there is a problem that the joint strength between the heat pipe and the heat conducting plate is low. Due to such a problem, heat resistance between the heat pipe and the heat absorption part (heat dissipation part) becomes higher, and excellent heat transport ability of the heat pipe cannot be utilized.

The present invention has been made in view of the foregoing, and an objective of the present invention is to provide a temperature control device and a method of manufacturing the temperature control device capable of joining a heat conducting plate and a heat pipe with high joint strength without damaging the heat pipe by heat. Solution to Problem

To solve the problem described above and achieve the object, a temperature control device according to the present invention includes: a heat pipe including a heat absorption part provided at one end side and absorbing heat from an outside and a heat dissipation part provided at another end side and dissipating heat to the outside, and adapted to control a temperature of an object to be temperature-controlled; and a metal film formed by powder including metal being accelerated with a gas toward external surfaces of the heat absorption part and/or the heat dissipation part, and being sprayed and deposited on the surfaces in a solid-phase state.

Moreover, in the temperature control device described above, a part of the external surface of the heat absorption part of the heat pipe is in contact with the object to be temperature-controlled, and the external surface other than a contact part is covered with the metal film.

Moreover, in the temperature control device described above, the metal used for the metal film includes at least one kind selected from a group consisting of copper, molybdenum, aluminum, tungsten, silver, nickel, titanium, and a stainless based alloy or an alloy including at least one of copper, molybdenum, aluminum, tungsten, silver, nickel, and titanium.

Moreover, a method of manufacturing a temperature control device according to the present invention is a method of manufacturing a temperature control device including a heat pipe adapted to control a temperature of an object to be temperature-controlled, and the method includes: a step of forming a metal film by accelerating powder including metal with a gas toward a surface of at least one end portion of the heat pipe and by spraying and depositing the powder on the surface in a solid-phase state.

Moreover, the method of manufacturing a temperature control device described above further includes a step of holding the heat pipe by a jig holding a part of the surface of the end portion of the heat pipe, and wherein the step of forming a metal film includes a first step of forming the metal film by accelerating powder including metal with a gas toward a surface exposed outside and of the heat pipe held by the jig in the step of holding the heat pipe, and by spraying and depositing the powder on the surface in a solid-phase state, and a second step of forming the metal film by removing the jig after the first step of forming the metal film, by accelerating powder including metal with a gas toward a surface of the heat pipe, having exposed outside, and by spraying and depositing the powder on the surface in a solid-phase state. Advantageous Effects of Invention

The temperature control device and the method of manufacturing the temperature control device according to the present invention joins end portions of a heat pipe and heat conducting plates with films formed by a cold spray method. Therefore, there is an effect of joining the heat conducting plates and the heat pipe with high joint strength without damaging the heat pipe by heat.

### Brief Description of Drawings

FIG. 1 is a perspective view schematically illustrating a configuration of a temperature control device according to an embodiment of the present invention.
FIG. 2 is a schematic diagram illustrating an outline of a cold spray apparatus used for manufacturing the temperature control device according to the embodiment of the present invention.
FIG. 3 is a cross sectional view describing formation of a heat dissipation plate of the temperature control device according to the embodiment of the present invention.
FIG. 4 is a cross sectional view describing formation of the heat dissipation plate of the temperature control device according to the embodiment of the present invention.
FIG. 5 is a cross sectional view describing formation of the heat dissipation plate of the temperature control device according to the embodiment of the present invention.
FIG. 6 is a cross sectional view describing formation of the heat dissipation plate of the temperature control device according to the embodiment of the present invention.
FIG. 7 is a cross sectional view describing formation of the heat dissipation plate of the temperature control device according to the embodiment of the present invention.
FIG. 8 is a cross sectional view illustrating a configuration of a principal part of a temperature control device according to a first modification of the embodiment of the present invention.
FIG. 9 is a cross sectional view illustrating a configuration of a principal part of a temperature control device according to a second modification of the embodiment of the present invention.
FIG. 10 is a cross sectional view illustrating a configuration of a principal part of a temperature control device according to a third modification of the embodiment of the present invention.

### Description of Embodiments

Hereinafter, an embodiment for implementing the present invention will be described in detail with reference to the drawings. Note that the present invention is not limited by the embodiment below. Further, the drawings referenced by the description below merely illustrate the shape, the size, and the positional relationship in a schematic manner to the extent that the content of the present invention can be understood. That is, the present invention is not limited by the shape, the size, and the positional relationship exemplarily illustrated in the drawings.

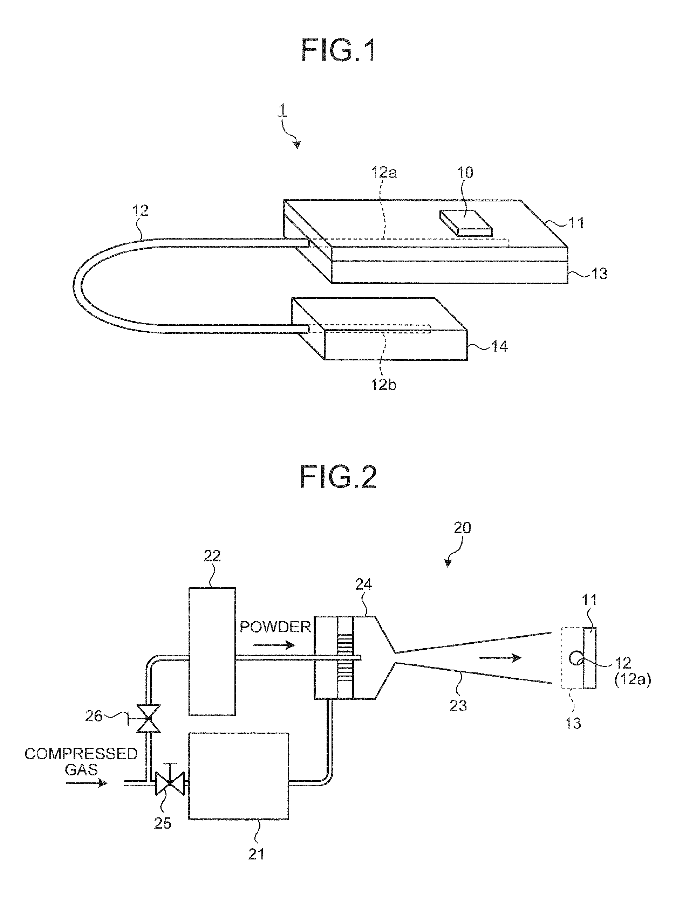

First, a temperature control device according to an embodiment of the present invention will be described in detail with reference to the drawings. Note that, in the description below, a temperature control device that cools a board, which incorporates a semiconductor device, will be described as an example of a temperature control device. FIG. 1 is a perspective view schematically illustrating a configuration of the temperature control device according to the embodiment of the present invention. A temperature control device 1 illustrated in FIG. 1 includes a board 11 that incorporates a chip 10 realized by a semiconductor device, such as a diode, a transistor, and an insulated gate bipolar transistor (IGBT), and a heat pipe 12 that cools the board 11.

A circuit pattern (not illustrated) for transferring an electrical signal to the chip 10, which is incorporated in the board 11, is formed on a surface of the board 11, which is not joined to the heat pipe 12. This circuit pattern is formed by patterning using metal, such as copper. Note that a plurality of chips 10 is provided on the board 11 according to a purpose of use.

The heat pipe 12 includes a heat absorption plate 13 joined to the board 11 and holding one end of the heat pipe 12, and a heat dissipation plate 14 formed at an end portion of the heat pipe 12 on a different side from the side connected with the board 11. Further, the heat pipe 12 includes a heat absorption part 12a provided in an end portion on the board 11 side, and a heat dissipation part 12b provided in an end portion on the different side from the board 11 side.

The heat absorption plate 13 and the heat dissipation plate 14 as heat conducting plates are metal films formed on surfaces of the heat absorption part 12a and of the heat dissipation part 12b of the heat pipe 12 by a cold spray method described below. Examples of the metal films include copper, molybdenum, aluminum, tungsten, silver, nickel, titanium, and a stainless based alloy or an alloy including at least one of copper, molybdenum, aluminum, tungsten, silver, nickel, and titanium. With the metal films, heat generated from the chip 10 can be efficiently absorbed by the heat absorption part 12a through the board 11, and the heat conducted to the heat dissipation part 12b can be efficiently dissipated to an outside. Here, as the metal films, any metal or alloy having the density of 95% or more and the heat conductivity of 90% or more with respect to a bulk material of the same kind is applicable.

Next, formation of the heat absorption plate 13 (metal film) of the heat absorption part 12a will be described with reference to FIG. 2. FIG. 2 is a schematic diagram illustrating an outline of a cold spray apparatus used for the formation of the metal film. A cold spray apparatus 20 includes a gas heater 21 that heats a compressed gas, a powder supply device 22 that houses a powder material thermally sprayed onto an object to be sprayed and supplies the powder material to a spray gun 24, and a gas nozzle 23 that thermally sprays material powder mixed with the heated compressed gas onto a base material with the spray gun 24.

Examples of the compressed gas include helium, nitrogen, and air. The supplied compressed gas is supplied to the gas heater 21 and to the powder supply device 22 by valves 25 and 26, respectively. The compressed gas supplied to the gas heater 21 is heated to about 50 to 700°C, and is then supplied to the spray gun 24. More favorably, the compressed gas is heated such that an upper limit temperature of the powder thermally sprayed onto the board 11 is kept equal to or less than a melting point of the metal material. This is because, by keeping the heating temperature of the powder material to be equal to or less than the melting point of the metal material, oxidation of the metal material can be suppressed.

The compressed gas supplied to the powder supply device 22 is supplied such that the material powder having a particle diameter of about 10 to 100 µm in the powder supply device 22 is supplied to the spray gun 24 at a predetermined discharge rate. The heated compressed gas is caused to be a supersonic flow (about 340 m/s or more) with the gas nozzle 23 having a convergent divergent shape. The powder material supplied to the spray gun 24 is accelerated by being thrown into the supersonic flow of the compressed gas, and collides with the base material in a solid-phase state to form a film.

A metal film (heat absorption plate 13) as illustrated in FIG. 1 is formed by the above-described cold spray apparatus 20. Note that the cold spray apparatus is not limited to the cold spray apparatus 20 of FIG. 2 as long as one can form a film by allowing the material powder to collide with the base material in a solid-phase state. Further, it has been described in the present embodiment that the heat pipe 12 is in contact with the board 11. However, the metal film 13 may lie between the board 11 and the heat pipe 12. Such a configuration is applicable as long as it can transfer the heat generated by the board 11 to the heat absorption part 12a of the heat pipe 12.

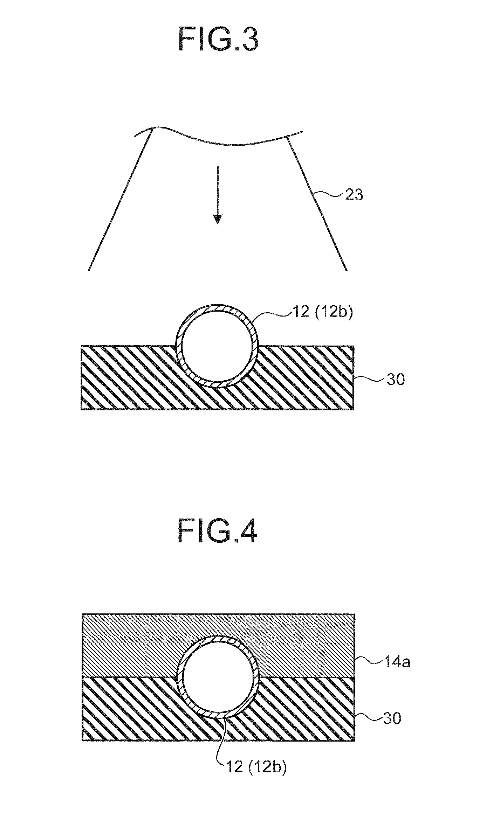

Next, formation of the heat dissipation plate 14 (metal film) of the heat dissipation part 12b will be described with reference to FIGS. 3 to 7. FIGS. 3 to 7 are cross sectional views describing the formation of the heat dissipation plate according to the embodiment. First, as illustrated in FIG. 3, a metal film 14a is formed so as to cover an external surface of the heat pipe 12 using the cold spray apparatus 20 illustrated in FIG. 2 with respect to the heat pipe 12 (heat dissipation part 12b) held by a jig 30. Here, the jig 30 has a recess portion that holds a part of the surface of an end portion of the heat pipe 12.

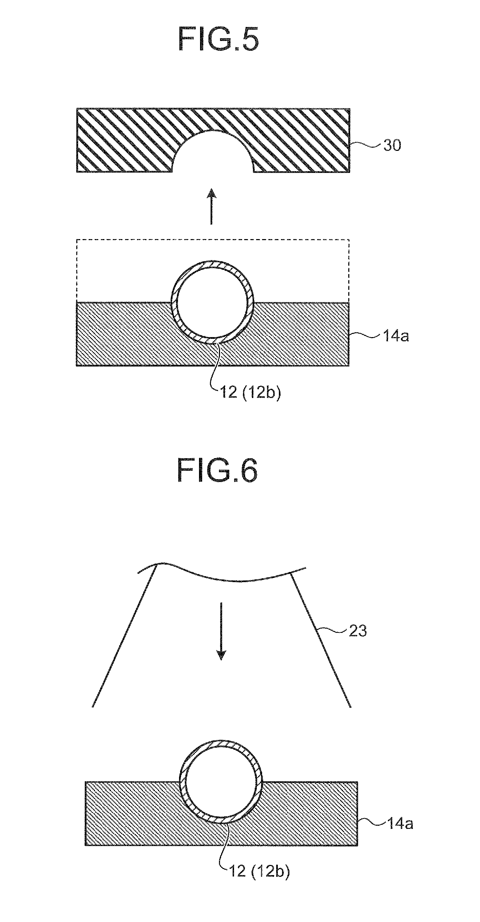

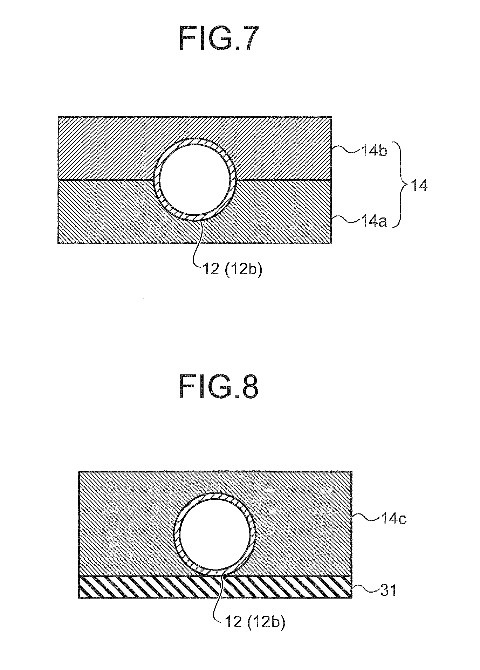

As illustrated in FIG. 3, after one external periphery of the heat pipe 12 is covered with the metal film, a film formation (see FIG. 4) formed by the metal film 14a being layered is inverted with respect to the cold spray apparatus 20, and the jig 30 is removed (FIG. 5). Following that, a metal film 14b is formed on the external surface of the heat pipe 12 that had been covered by the jig 30 (FIGS. 6 and 7). Here, the jig 30 is formed using a material having a coefficient of linear thermal expansion substantially different from that of the metal used for the heat dissipation plate 14 to be formed. Consequently, the jig 30 can be easily removed from the heat pipe 12.

By the above-described processing, the external surface of the heat pipe 12 (heat dissipation part 12b) is covered with the metal films 14a and 14b, as illustrated in FIG. 7, and the heat dissipation plate 14 can be formed. Note that, in forming a film, in a case where a metal film along a surface shape formed by the jig 30 and the heat pipe 12 is formed, the shape of the surface can be controlled by applying surface finishing processing, such as machining.

According to the temperature control device of the above-described embodiment, the end portion of the heat pipe is covered with the metal film formed by the cold spray method. Therefore, the heat pipe is not damaged by heat, and the board and the heat pipe can be joined with high joint strength. Consequently, the limitation of a working temperature and an amount of heat transport caused in a past temperature control device made by solders and the like under a low melting point can be improved while the durability of the temperature control device can be enhanced.

Further, the cold spray method can form a more precise metal film than a thermal spray method that performs high-temperature processing. Therefore, the metal characteristic of the metal film formed by the cold spray method is superior to that of a metal film formed by the thermal spray method, and the like. Consequently, the heat conductivity of the metal film is improved, and more efficient heat conduction can be realized between the heat pipe and the heat absorption part (heat dissipation part). For example, a copper film by the cold spray method has the density of 95% or more than a copper bulk material. Also, in the cold spray method, the powder is heated only to the degree that the solid-phase state of the metal powder can be maintained, and the oxidation of the powder is suppressed. Therefore, the heat conductivity has a characteristic of 90% or more than the bulk material.

Note that the metal film has been described as a cooling fin that releases the heat generated from the chip. However, the metal film can be provided to heat the board and the like through the metal film.

Further, the metal film-forming region by the cold spray method is a region where a heated portion and the heat pipe are at least connected and where the joint may just be reliably performed, regardless of uniformity of the shape of the metal film.

Further, the heat pipe 12 has been described to have a U shape. However, any shape in a bent manner or in a linear manner other than the U shape may be employed.

FIG. 8 is a schematic diagram illustrating a configuration of a principal part of a temperature control device according to a first modification of the embodiment. As illustrated in FIG. 8, in a case where the heat pipe 12 is arranged adjacent to a base plate 31, on which a board and the like that are objects to be temperature-controlled are placed, a metal film 14c is formed on an surface on which the heat pipe 12 is arranged by a cold spray method.

Note that the base plate 31 may be a heat conducting sheet made of a heat absorption sheet or a heat dissipation sheet.

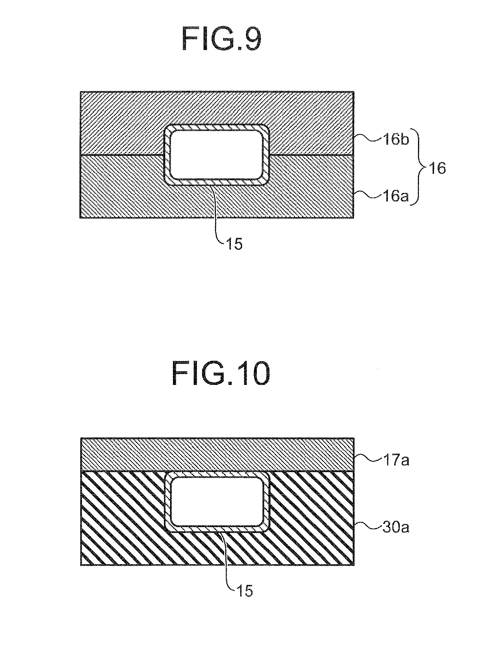

FIG. 9 is a schematic diagram illustrating a configuration of a principal part of a temperature control device according to a second modification of the embodiment. As illustrated in FIG. 9, a heat pipe 15 may have a cross section of an approximately rectangular shape. In this case, in a heat dissipation part, similarly to FIG. 7, a heat dissipation plate 16 is formed by forming metal films 16a and 16b using a jig. A surface of a heat pipe, which has a larger area, is caused to face a board, so that the area facing the board can be enlarged and efficiency of the heat transfer can be improved.

Further, FIG. 10 is a schematic diagram illustrating a configuration of a principal part of a temperature control device according to a third modification of the embodiment. As illustrated in FIG. 10, the heat pipe 15 having an approximately rectangular cross section may be held by a jig 30a that surrounds and holds three surfaces of the heat pipe 15. In this case, in a heat dissipation part, similarly to FIGS. 3 to 7, after a metal film 17a is formed using the jig, the metal film 17a is inverted and the jig 30a is removed, and a film is formed, so that a heat dissipation plate can be produced.

According to the third modification, a surface on which the metal film is formed by a cold spray method in the first process is flat. Thus, after the film is formed, surface finishing processing such as machining is not required for the surface, and therefore, the working process can be reduced.

### Industrial Applicability

As described above, the temperature control device and the method of manufacturing the same according to the present invention prevent the heat pipe from heat damage, and are useful when the board or the metal film and the heat pipe are joined with high joint strength. Reference Signs List

1 Temperature control device
10 Chip
11 Board
12 and 15 Heat pipe
12a Heat absorption part
12b Heat dissipation part
13 Heat absorption plate
14 Heat dissipation plate
20 Cold spray apparatus
21 Gas heater
22 Powder supply device
23 Gas nozzle
24 Spray gun
25 and 26 Valve

## Claims

1. A temperature control device comprising:
a heat pipe including a heat absorption part provided at one end side and absorbing heat from an outside and a heat dissipation part provided at another end side and dissipating heat to the outside, and adapted to control a temperature of an object to be temperature-controlled; and
a metal film formed by powder including metal being accelerated with a gas toward external surfaces of the heat absorption part and/or the heat dissipation part, and being sprayed and deposited on the surfaces in a solid-phase state.

2. The temperature control device according to claim 1,
wherein a part of the external surface of the heat absorption part of the heat pipe is in contact with the object to be temperature-controlled, and the external surface other than a contact part is covered with the metal film.

3. The temperature control device according to claim 1 or 2,
wherein the metal used for the metal film includes at least one kind selected from a group consisting of copper, molybdenum, aluminum, tungsten, silver, nickel, titanium, and a stainless based alloy or an alloy including at least one of copper, molybdenum, aluminum, tungsten, silver, nickel, and titanium.

4. A method of manufacturing a temperature control device including a heat pipe adapted to control a temperature of an object to be temperature-controlled, the method comprising:
a step of forming a metal film by accelerating powder including metal with a gas toward a surface of at least one end portion of the heat pipe and by spraying and depositing the powder on the surface in a solid-phase state.

5. The method of manufacturing a temperature control device according to claim 4, further comprising:
a step of holding the heat pipe by a jig holding a part of the surface of the end portion of the heat pipe, and
wherein the step of forming a metal film includes
a first step of forming the metal film by accelerating powder including metal with a gas toward a surface exposed outside and of the heat pipe held by the jig in the step of holding the heat pipe, and by spraying and depositing the powder on the surface in a solid-phase state, and
a second step of forming the metal film by removing the jig after the first step of forming the metal film, by accelerating powder including metal with a gas toward a surface of the heat pipe, having exposed outside, and by spraying and depositing the powder on the surface in a solid-phase state.
